# EUROPEAN PATENT APPLICATION

(11) **EP 4 779 052 A1**
(43) Date of publication of application: **22.07.2026**
(21) Application number: 24864696.0
(22) Date of filing: 12.09.2024
(51) Int. Cl.: C23C 16/04, C23C 16/458

(54) **CUT CELL, MODULE, AND PASSIVATION COATING METHOD FOR SIDE CUT SURFACE OF CELL**

(30) Priority: 13.09.2023 CN 202311175922
(71) Applicant: Ideal Deposition Equipment And Applications (Shanghai) Co., Ltd., Shanghai 201614 (CN); Ideal Deposition Equipment And Applications (Zhejiang) Co., Ltd., Jiaxing, Zhejiang 314499 (CN)
(72) Inventor: XI, Ming, Shanghai 201614 (CN); SU, Qingfeng, Shanghai 201614 (CN); TANG, Liangcai, Shanghai 201614 (CN); SONGJIANG, Xingzi, Shanghai 201614 (CN); TIAN, Jingkun, Shanghai 201614 (CN); LIU, Feng, Shanghai 201614 (CN); LU, Yong, Shanghai 201614 (CN)
(74) Representative: Schulz Junghans Patentanwälte PartGmbB
(86) International application number: PCT/CN2024/118501
(87) International publication number: WO 2025/055982

(57) **Abstract**

The present application discloses a cut solar cell pieces, a module thereof, and a passivation film deposition method for side cut faces of solar cell pieces. The passivation film deposition method includes the following steps: stacking the cut solar cell pieces, then placing the solar cell pieces into a plurality of boxes with processing windows on side surfaces, placing the boxes with the solar cell pieces in a pre-passivation area, wherein each of the boxes contains a plurality of the solar cell pieces; placing a plurality of the boxes from the pre-passivation area onto a tray within a reaction chamber; feeding reactant and carrier gas into the reaction chamber through a gas path system; performing passivation film deposition on the side cut faces of the solar cell pieces within the reaction chamber, namely forming a passivation film on the side cut faces of the solar cell pieces by deposition; after passivation film deposition on the side cut faces, placing the boxes onto a post-passivation area from the tray. According to the present application, the passivation of the side cut faces of the cut solar cell piece is realized, the efficiency of the solar cell module is improved, the technical problem of yield rate loss caused by poor welding of the solar cell module due to the over-depositing of the passivation film on the front surface or the back surface of the solar cell module is avoided, and the power generation cost of the solar cell module is reduced.

## Description

### FIELD

The present application relates to the field of solar cells, in particular to a solar cell piece with a film-deposited side cut face, a module produced from the solar cell pieces and a passivation film deposition method for side cut faces of solar cell pieces.

### BACKGROUND

In recent years, new solar module technologies such as half-cell solar modules and shingled solar modules have emerged. When manufacturing solar modules, one solar cell needs to be split into two or more pieces. In industrial application, the solar cell is cut by laser scribing and mechanical breaking, or thermal laser low damage breaking. The section (side cut face) of the silicon wafer formed after cutting the solar cell has a high surface recombination velocity, which may negatively affect the electrical property of the solar cell. For example, after a Topcon solar cell is split into two by laser scribing, the section of the Topcon solar cell is an unpassivated silicon wafer section, the conversion efficiency of the half-cell is reduced by 0.2-0.3% due to the increased recombination velocity of the section edge. For heterojunction solar cells, the conversion efficiency is reduced even more greatly after laser scribing due to the higher open-circuit voltage thereof. The reduced efficiency of the solar cell resulting from the cutting directly results in reduced power for the module produced from the cut solar cells.

The term "passivation film deposition" refers to the formation of a passivation film on the surface of a solar cell through deposition, so that minority carrier recombination is reduced, a field passivation effect is provided, and the reflectivity is reduced. With the increasing quality of the N-type silicon wafer and the increasing efficiency of the solar cell, the loss caused by cutting is also increased. There are several publications that recites this loss can be reduced by passivation film deposition the side cut face of the silicon wafer.

Generally, the function of the passivation film is to saturate silicon dangling bonds exposed on the surface of the silicon wafer and establish field passivation, and the two functions can be satisfied at the thickness of several atomic layers, so that the thickness of the passivation film is generally considered to be around 10 nm. Chinese patent publication CN111430506A also clearly indicates a passivation film thickness of 10 nm or 15 nm, which does not disclose specific passivation effects. Similarly, the perspective of article "Solar Energy Materials and Solar Cells 258 (2023)112429" suggests that a film thickness of 8 to 14nm is sufficient to achieve the desired passivation effect.

Meanwhile, in order to improve the production efficiency, it is conceivable to stack the solar cell pieces and perform passivation film deposition on the cut faces. However, the height of the metal grid lines on the front surface and the back surface of the printed solar cell piece is usually between 10 and 30 µm, and the existence of the metal grid lines causes gaps among the stacked solar cell pieces. The passivation repair film extends into these gaps during deposition, a phenomenon known as over-depositing. When the over-depositing film is deposited on the welding points on the front surface and the back surface of the solar cell piece, poor contact can be caused, and the yield of the correspondingly manufactured solar module is negatively influenced.

In the prior art, one way to solve the problem of over-depositing is to cut and passivation film depositing the solar cell piece before printing the metal grid lines on the solar cell piece, so that the welding points on the surface of the solar cell are not influenced by over-depositing. However, the following technical problems occur in this processing method: 1) the solar cell pieces without grid lines can be scratched due to mutual friction; 2) printing half-cells or smaller (shingles) can significantly reduce the throughput of the printing line, thereby increasing the capital cost of the production line and resulting in significant cost increases.

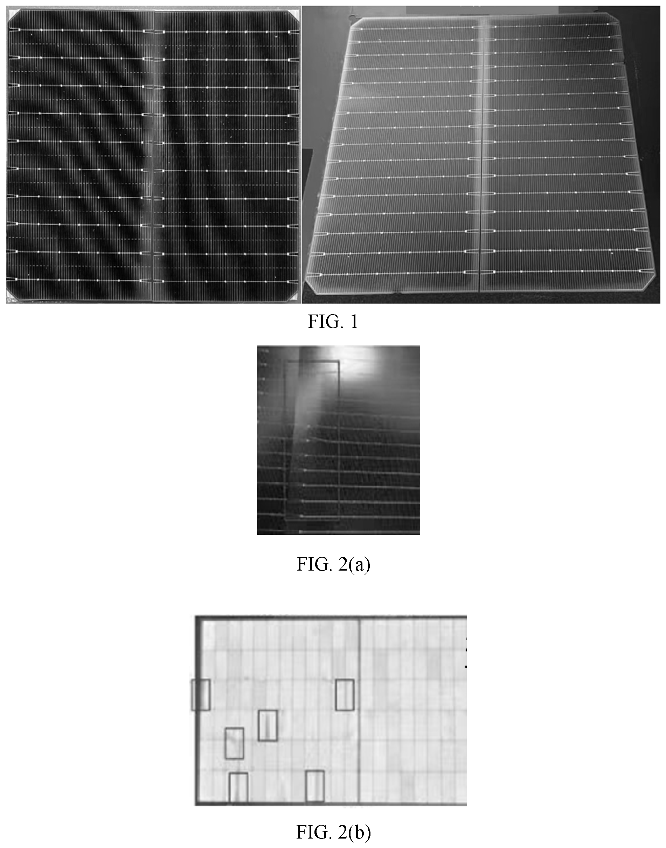

The passivation film deposition method for side cut faces disclosed in the Chinese patent publication CN111430506A does not mention the problem of over-depositing, and further does not mention how to solve the problem. FIG. 1 is a photo of a solar cell piece after being deposited by the deposition method according to the prior art, it can be seen that the phenomenon of over-depositing is severe, a passivation film is formed on a welding point of a metal welding strip on the front and back surfaces of the solar cell, so that the contact between the welding strip and the metal welding point is affected. The EL picture of the solar module made of the cut solar cell pieces shows dark spots, resulting in reduced efficiency and reliability, and low yield rate (FIG. 2).

The inventors find that when the existing deposition technology is adopted and the film thickness is within the disclosed coating thickness range, poor contact is caused when a over-depositing film is deposited on welding points on the front surface and the back surface of a solar cell piece, the contact between the welding points of the solar cell piece and the welding strip is influenced, local EL dark spots are caused, and finally the yield rate of a correspondingly manufactured solar module is influenced.

Therefore, the technical challenge that urgently needs to be solved by those skilled in the art is to overcome the shortcomings of the existing technology, provide an improved solar cell and its module, as well as a corresponding side cut face passivation film deposition method, to improve the efficiency of solar cells and their modules, while ensuring the yield of their modules and ultimately reducing the cost of power generation from the modules.

### SUMMARY

The present application aims to overcome the defects in the prior art, and provides a cut solar cell piece with passivation film deposited side cut face, a module thereof and a method for passivation film deposition a side cut faces of solar cell pieces, under the condition of ensuring that the printing productivity is not reduced, so that the efficiency of the solar cell piece is effectively improved. The present application also aims to substantially reduce the adverse effect generated by over-depositing, improve the efficiency and the yield rate of the corresponding solar cell module and reduce the power generation cost of the module. Furthermore, the adoption of the side cut face passivation film deposition method can obviously reduce the phenomenon of over-depositing and the adverse effect caused by the over-depositing.

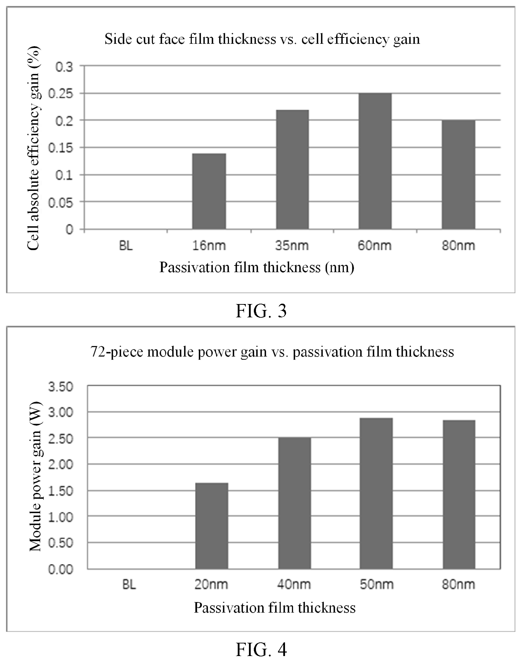

More unexpectedly, the inventor finds that, in the process of research, contrary to common understanding in existing technologies, the passivation effect shows a significant improvement when the passivation film thickness on the side cut face of the cut solar cell piece is greater than 20 nm, and particularly greater than 25 nm, especially when it approaches 30 nm, and then continuously rises with the increase of the thickness of the passivation film, and then become relatively stable when the thickness of the passivation film is between 60 and 80 nm. For example, compared with a sample Baseline (BL) of a half-cell without passivation film deposition on the side cut face thereof, when the passivation film thickness is in a range of 0 to 60nm, the efficiency of the solar cell piece increases with the thickness of the passivation film, and when the thickness of the passivation film reaches above 60 nm, the film thickness increases and the efficiency of the solar cell piece does not increase any more, indicating that the passivation effect is saturated (FIG. 3). The power output of the respective solar modules shows substantially the same trend of improvement (FIG. 4).

To this end, a first aspect of the present application relates to a cut cell piece, wherein a side cut face of the solar cell piece is deposited with a passivation film of aluminum oxide, a width of over-depositing on a front surface or back surface of the solar cell piece is between 0.1 and 1.5mm, and the cut solar cell piece is printed and sintered with metal grid lines before cutting.

Preferably, the width of over-depositing on the front surface or the back surface of the solar cell piece is between 0.1 and 1.0 mm.

Preferably, a thickness of the passivation film is between 55 and 100 nm. More preferably, the thickness of the passivation film is between 40 and 60 nm.

A second aspect of the present application also relates to a cut solar cell piece, wherein a side cut face of the solar cell piece is deposited with a passivation film of between 21 and 100 nm of aluminum oxide, and the cut solar cell piece is printed and sintered with metal grid lines before cutting.

Preferably, a thickness of the passivation film is between 25 and 80 nm, and more preferably, the thickness of the passivation film is between 30 and 60 nm.

Preferably, a width of over-depositing on the front surface or the back surface of the solar cell piece is between 0.1 and 1.5 mm, and more preferably, the width of over-depositing on the front surface or the back surface of the solar cell piece is between 0.1 and 1.0 mm.
preferably, the material of the passivation film is any one of the following materials: aluminum oxide, silicon nitride, silicon oxynitride, silicon oxide, polycrystalline silicon, and amorphous silicon.

A third aspect of the present application relates to a solar cell module,
wherein the solar cell module comprises a plurality of cut solar cell pieces deposited with films after cutting according to the first aspect and/or the second aspect of the present application, and is prepared according to a known method.

The application relates to a passivation film deposition method for side cut faces of solar cell pieces after cutting, comprising the following steps:
step S101: stacking the cut solar cell pieces, then placing the solar cell pieces into a plurality of boxes with processing windows on side surfaces, placing the boxes with the solar cell pieces in a pre-passivation area, wherein each of the boxes contains a plurality of the solar cell pieces;
step S102: placing a plurality of the boxes from the pre-passivation area onto a tray within a reaction chamber;
step S103: feeding reactant and carrier gas into the reaction chamber through a gas path system;
step S104: performing passivation film deposition on the side cut faces of the solar cell pieces within the reaction chamber, namely forming a passivation film on the side cut faces of the solar cell pieces by deposition, with a reaction temperature of between 100 and 500 °C and a reaction pressure of between 0-200 Torr;
step S105: after passivation film deposition on the side cut faces, placing the boxes onto a post-passivation area from the tray.

Preferably, in step S101, a number of between 10 and 2000 solar cell pieces are placed into each of the boxes.

Preferably, in step S101, a number of between 200 and 600 solar cell pieces are placed into each of the boxes.

Preferably, before step S101, the method further comprises step S100: cutting the solar cell pieces after printing and sintering;
preferably, during cutting of the solar cell pieces, the solar cell pieces are scribed by laser scribing, and during the laser scribing, the solar cell pieces are split by water spraying.

Preferably, after step S105, an oxygen-free cooling step is also performed to cool the solar cell pieces formed with the passivation film to room temperature in an oxygen-free environment.

Preferably, between step S104 and step S105, an annealing step is further performed to perform annealing processing.

Preferably, the reaction temperature is between 100 and 300 °C, and the reaction pressure is between 0 and 100 Torr.

Compared with the prior art, the present application has the following advantages:
according to the solar cell piece, the solar cell module and the passivation film deposition method for side cut faces provided by the present application, the conversion efficiency loss caused by cutting the solar cell pieces can be reduced, the adverse effect caused by over-depositing can be greatly reduced, the efficiency of the solar cell module improved, and the power generation cost of the assembly is reduced.

### BRIEF DESCRIPTION OF THE DRAWINGS

FIG. 1 is a schematic diagram of a solar cell piece deposited by the prior art.
FIG. 2(a) is a picture of a front surface of a solar cell piece with over-depositing in the prior art, and FIG. 2(b) is an EL picture of a solar cell module manufactured from the solar cell pieces with over-depositing, and wherein over-depositing portion influences the contact of cell welding points and welding strips to cause local EL dark spots.
FIG. 3 is a graph showing the relationship between the thickness of the deposited film on the side cut face after cutting and the gain in the efficiency of the solar cell piece.
FIG. 4 is a graph showing the relationship between the thickness of the deposited film on the side cut face after cutting and the gain in the efficiency of the solar cell module.
FIG. 5 is a schematic structural diagram of an apparatus used in the passivation film deposition method for side cut faces according to the present application.
FIG. 6 is a schematic view of a box used in the passivation film deposition method for side cut faces according to the present application.
FIG. 7 is a flow chart of the passivation film deposition method for side cut faces according to the present application.
FIG. 8 is a schematic view of a placement manner within the box according to the film deposition method of the present application.
FIG. 9 is a schematic view of another placing manner within the box according to the film deposition method of the present application.
FIG. 10 is a schematic diagram of the solar cell piece deposited by passivation film deposition method for the side cut faces as shown in FIG. 7.

### DETAILED DESCRIPTION

The following describes the technical solutions in the embodiments of the present application in detail with reference to the drawings in the embodiments of the present application. It is to be understood that the following examples are only some specific embodiments of the present application, and are not intended to be exhaustive. The following description of the exemplary embodiment(s) is merely illustrative of the application and is not intended to limit the application or its application or uses. Based on the description in this application, all other technical solutions obtained by a person skilled in the art without inventive effort are within the scope of protection of the present application.

For ease of description, the present application uses spatial relative terms such as "above", "on top of", "on the upper surface of", "on", etc., to describe the spatial positional relationship between a device or feature and other devices or features as shown in the figure. It will be understood that the spatially relative terms are intended to encompass different orientations of the device in use or operation in addition to the orientation depicted in the figures. For example, if a device in the attached figure is inverted, a device described as "above" or "on top of" will be positioned as "below" or "under". Therefore, the exemplary term "above" can include both "above" and "below". The device may be otherwise variously oriented (rotated 90 degrees or at other orientations), and the spatially relative descriptors used herein interpreted accordingly.

To this end, a first aspect of the present application relates to a cut cell piece, wherein a side cut face of the solar cell piece is deposited with a passivation film of aluminum oxide, a width of over-depositing on a front surface or back surface of the solar cell piece is between 0.1 and 1.5mm, and the cut solar cell piece is printed and sintered with metal grid lines before cutting.

Preferably, the width of over-depositing on the front surface or the back surface of the solar cell piece is between 0.1 and 1.0 mm.

The side cut face is deposited with a passivation film with a thickness of between 55 and 100 nm. Preferably, the thickness of the passivation film is between 40 and 60 nm.

A second aspect of the present application also relates to another cut solar cell piece, wherein a side cut face of the solar cell piece is deposited with a passivation film of between 55 and 100 nm of aluminum oxide, and the cut solar cell piece is printed and sintered with metal grid lines before cutting.

Preferably, the thickness of the passivation film is between 40 and 60 nm.

Preferably, a width of over-depositing on a front surface or a back surface of the solar cell piece is between 0.1 and 1.5 mm, and more preferably, the width of over-depositing on the front surface or the back surface of the solar cell piece is between 0.1 and 1.0 mm.

A third aspect of the present application relates to a solar cell module manufactured from a plurality of the cut solar cell pieces according to the first aspect and/or the second aspect of the present application by using a known technique.

A fourth aspect of the present application relates to a passivation film deposition method for side cut faces of solar cell pieces. As shown in FIG. 2, a device used in the passivation film deposition method for the side cut faces of the solar cell pieces comprises a reaction chamber 1, a sprayer 2, a rotating device 3, a tray 4, heaters 5, and an air path system.

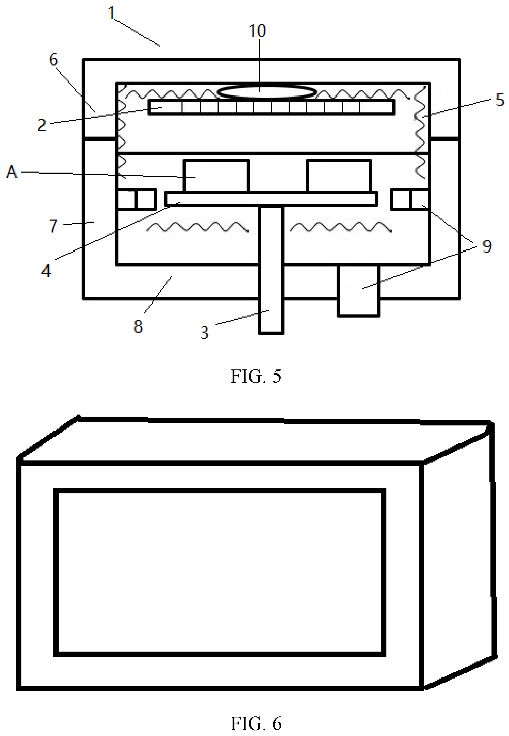

As shown in FIG. 5, the reaction chamber 1 is preferably circular, but is not limited thereto, and may have other shapes according to actual needs. The reaction chamber 1 shown in FIG. 5 consists of a top cover 6, a side portion 7, and a bottom portion 8, and may further comprise other components as necessary.

The sprayer 2 is a spray plate in a downward spraying mode (showerhead) and configured to provide reactants for side cut faces passivation film deposition with the gas path system. The gas path system preferably comprises: a first deposit gas line, a second deposit gas line, and a purge/supplemental gas line. The gas path system further preferably comprises a temperature control and liquid supplementing system. The first deposition gas line (or the second deposition gas line) is composed of, for example, an MFC (Mass Flow Controller), a source tank, a pneumatic valve, a connecting line, etc., and may further comprise a PC (pressure controller). The purge/supplemental gas line is composed of, for example, an MFC (gas flow controller), a pneumatic valve, a connecting line, and the like.

The reactant is preferably TMA1 (trimethylaluminum) and H₂O, but is not limited thereto. Other reactants may be suitably used depending on the specific deposition film, for example, various aluminum-containing organic metals such as triethylaluminum, dichloroethylaluminum, and chlorodiethylaluminum, and O-containing gaseous substances such as O₃, H₂O₂, or O₂ after plasma ionization. TMA1 and H₂O flow into the source tank by way of a centralized liquid supply, and inert gas such as N2 or Ar is used as a carrier gas. After the carrier gas is introduced into the source tank, the TMA1 and H₂O are carried out according to the saturated vapor pressure and the principle of the bubbling method, and enter the reaction chamber 1. When TMA1 and H₂O are used as reactants and N₂ is used as the carrier gas, the passivation film as formed is AlOx. However, the passivation film is not limited to AlOx and may be other suitable materials such as poly-Si, SiOx, SiNx, and the like.

As shown in FIG. 5, the rotating device 3 is provided at the bottom portion of the reaction chamber 1. The rotation device 3 preferably comprises a shaft and a motor, but may comprise other components as required. The tray 4 is disposed on top of the rotating device 3. A bottom portion of the tray 4 is connected to the rotating device 3, and the rotating device 3 is configured to rotate the tray 4. In the reaction chamber 1, the tray 4 is disposed opposite to the shower 2, i.e., a bottom surface (gas outlet surface) of the sprayer 2, as shown in FIG. 2, is disposed opposite to an upper surface of the tray 4. The material of the tray 4 is preferably graphite, metal, or the like, but is not limited thereto, and any other suitable material may be used as needed. A plurality of boxes A may be placed on the tray 4. The distance between the bottom surface of the sprayer 2 and the upper surface of the tray 4 may be between 1.0 and 50 cm. The height of the box A may be between 0.2 and 30cm, and therefore the gap between the upper end surface of the box A and the air outlet surface of the sprayer 2 may be between 0.8 and 20 cm.

When the film deposition the side cut faces, the box a is used for receiving and shielding the cut solar cell pieces of which the side cut faces need to be passivated. For example, a number of 10 to 2000 cut solar cell pieces, preferably 200 to 600 pieces, may be stacked in each box A. The solar cell pieces in the box A are in as close contact as possible with each other without being damaged. As shown in FIG. 6, a processing window is arranged on a side surface of the box A, so that the side cut faces of the solar cell pieces are exposed in the passivation film deposition atmosphere for passivation during the film deposition process. The number of the boxes A may be more than 2, preferably more than 4, more preferably more than 8, or may be any number according to actual needs.

The box A may be positioned in the reaction chamber at any angle and manner suitable for film deposition. The placement manners of the boxes A on the tray 4 can be various. For example, the boxes A may be placed to face a center of the tray, face away from the center of the tray, rotate a windward side thereof, or rotate a leeward side thereof, wherein a placement angle can be, for example, perpendicular to a plane of the tray.

The total number of the solar cell pieces within the boxes A placed on the tray 4 can reach up to thousands of pieces. The total weight of the tray 4, the boxes A and the solar cell pieces can reach up to 100 kg or even higher. And at the moment, the rotating device 3 is provided with a driving device which is capble of ensuring rotation of the tray. Preferably, when the weight of the boxes A and the solar cell pieces exceeds 10 kg, a fixing device capable of fixing the tray 4 to the rotating device is further provided, and the fixing device is configured to ensure a stable rotation of the tray 4.

The heaters 5 are provided below and on both sides of the tray 4 to maintain a reaction temperature, and heating elements are included inside the heaters 5. The heaters 5 disposed below the tray 4 and the heaters 5 disposed on both sides of the tray 4 are preferably of an integral structure. The heaters 5 disposed below the tray 4 can preferably heat the interior of the reaction chamber to a temperature of 450 °C or even higher. The heaters 5 disposed on both sides of the tray 4 can preferably achieve uniform heating along the vertical direction. For example, the heating intensity of the heaters 5 may increase with increasing height along the direction of bottom to top. For example, the number of heating elements may increase with increasing height. The heating element may be, for example, a resistance wire, or any other suitable element. The temperature difference from the lower end surface to the upper end surface of the box A is preferably within 5 degrees Celsius. More preferably, as shown in FIG. 5, the heaters 5 are provided below the top cover 6 to enhance uniform heating in the reaction chamber 1, but not limited thereto, and the heaters 5 may not be provided below the top cover 6.

Preferably, a valve opening is provided in the side portion 7 of the reaction chamber 1, through which a transport system is connected. The valve opening is in operation communication with the transport system via a transport means. The transfer system, for example, may be a conveyor belt. The transfer mechanism is preferably a clamping jaw, such as a cantilever clamping jaw, for placing the box A containing the un-passivated solar cell pieces into the tray 4 and for removing the box A containing the passivated solar cell pieces from the tray 4. The cantilever clamping jaw is adapted to the boxes A to effect the desired movement of box A within the reaction chamber, including, but not limited to, lifting, lowering, or parallel movement of the boxes A.

In addition, an air exhaust system 9 is further arranged to exhaust air generated in the passivation film deposition process, and the air exhaust system 9 is connected with a vacuum pump to guarantee the vacuum degree of the chamber. The air exhaust system 9 comprises an air extraction means provided at the bottom portion 8 and air extraction channels provided at the side portion 7. The air extraction means provides a substantially even flow under reaction conditions, without dead zones of flow. As shown in FIG. 5, the air extraction channels are arranged at substantially the same height as the tray 4.

As shown in FIG. 5, a heating source 10 for temperature holding is further included between the sprayer 2 and the top cover 6 for generating plasma to assist deposition. The heating source 10 for temperature holding is used to maintain the temperature, and may be a heater, for example, to assist the deposition method, such as ALD. However, the heating source 10 for temperature holding is not essential, and the heating source 10 for temperature holding may not be provided.

In addition, a power supply device is also arranged to supply power to the whole passivation film deposition equipment. The power supply device is preferably an electric cabinet and can also be other suitable power supply devices.

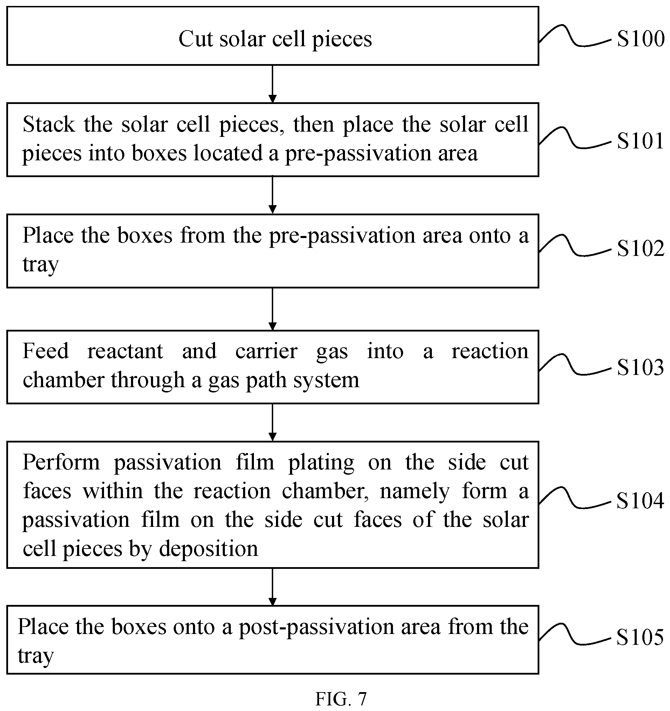

As shown in FIG. 7, a specific process of the film deposition method according to the third aspect of the present application is to perform step S100 first, comprising cutting the solar cell pieces. The cutting may be performed by laser scribing, but is not limited thereto, and other suitable cutting methods may also be used. And then step S101 is carried out, comprising stacking the cut solar cell pieces, then placing the solar cell pieces into a plurality of boxes with processing windows on side surfaces, placing the boxes with the solar cell pieces in a pre-passivation area, wherein each of the boxes contains a plurality of the solar cell pieces. And then step S102 is carried out, comprising placing a plurality of the boxes from the pre-passivation area onto a tray within a reaction chamber. And then step S103 is carried out, comprising feeding reactant and carrier gas into the reaction chamber through a gas path system. And then step S104 is carried out, comprising performing passivation film deposition on the side cut faces of the solar cell pieces within the reaction chamber, namely forming a passivation film on the side cut faces of the solar cell pieces by deposition. And finally, step S105 is carried out, comprising placing the boxes onto a post-passivation area from the tray after passivation film deposition on the side cut faces.

In addition, step S100 is not mandatory. Step S100 may not be performed, and steps S101 to S105 can be performed on the cut solar cell pieces.

Preferably, during performing step S100, the solar cell pieces are scribed by laser scribing, and during the laser scribing, the solar cell pieces are split by water spraying. Through water spraying, the contamination on the surface of the solar cell pieces can be removed, so that the surface of the solar cell pieces meets the cleanliness requirement, and over-depositing is reduced during film deposition.

Preferably, after step S105, an oxygen-free cooling step is also performed to cool the solar cell pieces formed with the passivation film to room temperature in an oxygen-free environment. The oxygen-free cooling refers to that the solar cell pieces after being deposited are in an oxygen-free state in the process of cooling from the deposition temperature to the room temperature. Namely, the solar cell pieces are not in contact with air. Therefore, the metal grid lines on the solar cell piece are prevented from being oxidized by oxygen in the air at high temperature, and the influence of the oxidation on the packaging of subsequent modules is avoided.

Preferably, between step S104 and step S105, an annealing step is further performed to perform annealing processing at an annealing temperature of between 100 and 450 °C.

Preferably, in step S104, the reaction temperature is between 100 and 600 °C, and the reaction pressure is between 0 and 200 Torr. More preferably, the reaction temperature is between 100 and 300 °C, and the reaction pressure is between 0 and 100 Torr.

After carrying out the passivation film deposition on the side cut faces by adopting the film deposition method above, the cut solar cell pieces are obtained. Tests prove that the efficiency of the solar cell piece is greatly improved after the passivation film deposition method. For example, the efficiency of a 144-piece module consisting of silicon wafers measuring 182 mm by 91 mm is improved by 6W.

The film deposition method according to the present application will be further described below based on the following examples.

### Example 1

The film deposition device comprises a circular reaction chamber 1, a sprayer 2 arranged in an upward spraying mode, a rotating device 3 comprising a rotating shaft and a motor, a tray 4 made of graphite, heaters 5 arranged below and on both sides of the tray 4, and an air path system. The circular reaction chamber 1 consists of a top cover 6, a side portion 7 and a bottom portion 8. No valve openings are provided on the side portion 7 of the circular reaction chamber 1. The heaters 5 disposed below the tray 4 and the heaters 5 disposed on both sides of the tray 4 are not of an integral structure, and no heating source for temperature holding is provided in the device.

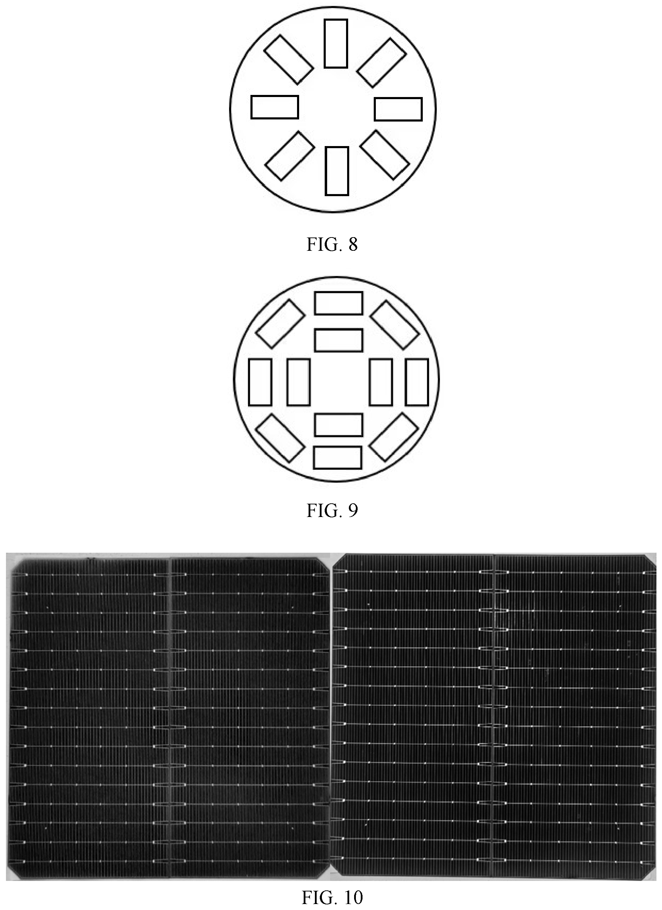

Firstly, solar cell pieces which are printed and sintered are cut into half-cells. After the side cut faces of the solar cell pieces are aligned, the solar cell pieces are placed into eight boxes. The solar cell pieces are tightly stacked on the premise that the solar cell pieces are not damaged. Each box is loaded with ten solar cell pieces. And then the boxes into which the solar cell pieces are placed are placed into a pre-passivation area. Then eight boxes are placed on the tray 4 from the pre-passivation area, and then the boxes are laid out in the manner shown in FIG. 8. The distance between the bottom surface of the sprayer 2 and the upper surface of the tray 4 is 11 cm. The height of the box is 10 cm. Therefore, the gap between the upper end surface of the box and the bottom surface of the sprayer 2 is 1 cm.

Reactants are TMA1 (trimethyl aluminum) and H₂O, and carrier gas is N₂, which are introduced into the reaction chamber through the gas path system. TMA1 and H₂O flow into the gas path system in a centralized liquid supply manner, and then N₂ is introduced into the gas path system, and the TMA1 and H₂O are carried out according to the saturated vapor pressure and the principle of the bubbling method and enter the reaction chamber 1. TMA1 and H₂O enter the reaction chamber 1 with N₂ as the carrier gas, and then carry out CVD reaction. The process reaction time is 5 minutes, the passivation film formed on the side cut face is Al₂O₃, and has a thickness of 35 nm. During the reaction, the reaction temperature was 200 °C, the flow rate of TMAl carried by N₂ was 500 sccm, the flow rate of H₂O carried by N₂ was 300 sccm, the flow rate of the purge gas N₂ was 5 slm, and the chamber pressure was 20 Torr.

After passivation film deposition on the side cut faces is completed, the eight boxes are all replaced to a post-passivation area from the tray 4.

After passivation film deposition on the side cut faces is completed via the deposition method of Example 1, the tested cell pieces had almost no over-depositing, with a front surface over-depositing of 0.7 mm and a back surface over-depositing of 0.5 mm as shown in FIG. 10. And the 72-piece module made therefrom has no occurrence of EL dark spots.

### Example 2

Example 2 uses a device similar to that of Example 1, except that a valve opening is provided in the side portion 7 of the circular reaction chamber 1 through which a conveyor belt is connected. The heaters 5 disposed below the tray 4 and the heaters 5 disposed on both sides of the tray 4 are of an integral structure, and the fixing device is provided.

Firstly, the cut solar cell pieces are stacked and placed into twelve boxes. The solar cell pieces are tightly stacked on the premise that the solar cell pieces are not damaged. Each box is loaded with ten solar cell pieces. And then the boxes into which the solar cell pieces are placed are placed into a pre-passivation area. The twelve boxes are then placed on the tray 4 from the pre-passivation area. FIG. 9 shows the layout of the twelve boxes. The distance between the bottom surface of the sprayer 2 and the upper surface of the tray 4 is 10.8 cm. The height of the box is 10 cm. Therefore, the gap between the upper end surface of the box and the bottom surface of the sprayer 2 is 0.8 cm. Through the valve opening, the cantilever clamping jaw puts the boxes containing the non-passivated solar cell pieces into the tray 4 from the pre-passivation area, and takes the passivated boxes of the solar cell pieces out of the tray 4. The cantilever clamping jaw is matched with the boxes so as to move the boxes, lift up and put down the boxes, and move the boxes back and forth.

Reactants are TMA1 and H₂O, and carrier gas is N₂, which are introduced into the reaction chamber through the gas path system. TMAl and H₂O flow into the gas path system in a centralized liquid supply manner, and then N2 is introduced into the gas path system, and the TMA1 and H₂O are carried out according to the saturated vapor pressure and the principle of the bubbling method and enter the reaction chamber 1. TMAl and H₂O enter the reaction chamber 1 with N₂ as the carrier gas, and then carry out CVD reaction. The reaction time is 20 minutes, the passivation film formed is Al₂O₃, and has a thickness of 50 nm. During the reaction, the reaction temperature IS 250 °C and the chamber pressure IS 5 Torr. After the Al₂O₃ deposition is completed, annealing is performed for 30 min at 300 °C.

After passivation film deposition on the side cut faces is completed, the twelve boxes are all replaced to a post-passivation area from the tray 4.

After passivation film deposition on the side cut faces is completed via the deposition method of Example 2, the tested cell pieces had almost no over-depositing, with a front surface over-depositing of 0.5 mm and a back surface over-depositing of 0.4 mm as shown in FIG. 10. The dimensions of the half-cells after passivation of the side cut faces are 182mm × 91mm. The 144-cell module (72-panel type) encapsulated by these half-cells increases the absolute power of the module to 6W.

The following table shows the test results for the 82mm × 91mm half-cells packaged into the 144-cell module. The unit of power is W, the unit of short-circuit current is A, the unit of open-circuit voltage is V, the unit of series resistance is Ω, and the fill factor represents the ratio of the maximum output power of the module to the incident light power. In the table below, the control refers to a module packaged from half-cells without passivation film deposition. The 55 nm group refers to a module packaged from half-cells after passivation film deposition according to Example 2. The 70 nm group refers to a module packaged from half-cells after passivation film deposition according to Example 2.

| 144-cell (182mm × 91mm) encapsulated module | | | | | |
|---|---|---|---|---|---|
| Type | Power (W) | Short-circuit current (A) | Open circuit voltage (V) | Series resistance (Ω) | Fill factor |
| Control Group | 593.40 | 13.79 | 53.06 | 0.33 | 81.08% |
| 55 nm group | 598.38 | 13.79 | 53.06 | 0.32 | 81.68% |
| 70 nm group | 599.48 | 13.79 | 53.13 | 0.32 | 81.96% |

Therefore, according to the passivation film deposition method disclosed by the present application, the side cut faces deposition repair is carried out on the printed solar cell pieces so as to reduce the over-depositing, the cutting loss of the cut solar cell piece can be repaired. Technical problems including over-depositing on the cut solar cell pieces and the efficiency loss caused by cutting the solar cell pieces are solved. The efficiency of the solar cell module is improved, and the power generation cost of the module is reduced.

Although the embodiments of the present application have been described in detail hereinabove, it is apparent to those skilled in the art that various modifications and variations can be made to the embodiments. However, it is to be understood that such modifications and variations fall within the scope and spirit of the present application as set forth in the following claims. Moreover, the application as described herein is capable of other embodiments and of being practiced or of being carried out in various ways.

## Claims

1. A cut solar cell piece, **characterized in that** a side cut face of the solar cell piece is deposited with a passivation film of aluminum oxide, a width of over-depositing on a front surface or back surface of the solar cell piece is between 0.1 and 1.5mm, and the cut solar cell piece is printed and sintered with metal grid lines before cutting.

2. The cut solar cell piece of claim 1, **characterized in that** the width of over-depositing on the front surface or the back surface of the solar cell piece is between 0.1 and 1.0 mm.

3. The cut solar cell piece of claim 1, **characterized in that** a thickness of the passivation film is between 55 and 100 nm.

4. The cut solar cell piece of claim 3, **characterized in that** the thickness of the passivation film is between 40 and 60 nm.

5. A cut solar cell piece, **characterized in that** a side cut face of the solar cell piece is deposited with a passivation film of between 55 and 100 nm of aluminum oxide, and the cut solar cell piece is printed and sintered with metal grid lines before cutting.

6. The cut solar cell piece of claim 5, **characterized in that** the thickness of the passivation film is between 40 and 60 nm.

7. The cut solar cell piece of claim 5, **characterized in that** a width of over-depositing on a front surface or back surface of the solar cell piece is between 0.1 and 1.5 mm.

8. The cut solar cell piece of claim 7, **characterized in that** the width of over-depositing on the front surface or the back surface of the solar cell piece is between 0.1 and 1.0 mm.

9. A solar cell module, **characterized in that** the solar cell module is manufactured from the cut solar cell piece according to any one of claims 1 to 8.

10. A passivation film deposition method for side cut faces of solar cell pieces, **characterized by** comprising the following steps:
step S101: stacking the cut solar cell pieces, then placing the solar cell pieces into a plurality of boxes with processing windows on side surfaces, placing the boxes with the solar cell pieces in a pre-passivation area, wherein each of the boxes contains a plurality of the solar cell pieces;
step S102: placing a plurality of the boxes from the pre-passivation area onto a tray within a reaction chamber;
step S103: feeding reactant and carrier gas into the reaction chamber through a gas path system;
step S104: performing passivation film deposition on the side cut faces of the solar cell pieces within the reaction chamber, namely forming a passivation film on the side cut faces of the solar cell pieces by deposition, with a reaction temperature of between 100 and 500 °C and a reaction pressure of between 0-200 Torr;
step S105: after passivation film deposition on the side cut faces, placing the boxes onto a post-passivation area from the tray.

11. The passivation film deposition method of claim 10, **characterized in that** before step S101, step S100 of cutting the solar cell piece is further provided.

12. The passivation film deposition method of claim 10 or 11, **characterized in that** metal grid lines are printed and sintered before the solar cell pieces are cut.

13. The passivation film deposition method of claim 10 or 11, **characterized in that** in step S101, a number of between 10 and 2000 solar cell pieces are placed into each of the boxes.

14. The passivation film deposition method of claim 10 or 11, **characterized in that** in step S101, a number of between 200 and 600 solar cell pieces are placed into each of the boxes.

15. The passivation film deposition method of claim 11, **characterized in that** during cutting of the solar cell pieces, the solar cell pieces are scribed by laser scribing, and during the laser scribing, the solar cell pieces are split by water spraying.

16. The passivation film deposition method of claim 10 or 11, **characterized in that** after step S105, an oxygen-free cooling step is also performed to cool the solar cell pieces formed with the passivation film to room temperature in an oxygen-free environment.

17. The passivation film deposition method of claim 10 or 11, **characterized in that** between step S104 and step S105, an annealing step is further performed to perform annealing processing.

18. The passivation film deposition method of claim 10 or 11, **characterized in that** in step S104, the reaction temperature is between 100 to 300 °C, and the reaction pressure is between 0 and 200 Torr.

19. A cut solar cell piece, **characterized in that** the cut solar cell piece is manufactured by the passivation film deposition method according to any one of claims 10 to 18.

20. The cut solar cell piece of claim 19, **characterized in that** a width of over-depositing on a front surface or back surface of the solar cell piece is between 0.1 and 1.5 mm.

21. The cut solar cell piece of claim 20, **characterized in that** the width of over-depositing on the front surface or the back surface of the solar cell piece is between 0.1 and 1.0 mm.

22. The cut solar cell piece of claim 19, **characterized in that** a thickness of the passivation film is between 55 and 100 nm.

23. The cut solar cell piece of claim 22, **characterized in that** the thickness of the passivation film is between 40 and 60 nm.
